# EUROPÄISCHE PATENTSCHRIFT

(11) **EP 3 096 980 B1**
(45) Veröffentlichungstag und Bekanntmachung des Hinweises auf die Patenterteilung: **21.03.2018**
(21) Anmeldenummer: 15709400.4
(22) Anmeldetag: 20.01.2015
(51) Int. Cl.: B60Q 1/068, F21S 8/10, H01S 5/00, H01S 5/022, H01S 5/40, G02B 7/02, G02B 7/00, H01S 5/02, H01S 5/024

(54) **LASEREINHEIT FÜR EINEN FAHRZEUGSCHEINWERFER**
LASER UNIT FOR A VEHICLE HEADLIGHT
UNITÉ LASER POUR PHARE DE VÉHICULE

(30) Priorität: 20.01.2014 AT 500322014
(43) Veröffentlichungstag der Anmeldung: 30.11.2016
(73) Patentinhaber: ZKW Group GmbH, 3250 Wieselburg (AT)
(72) Erfinder: MAYER, Matthias, A-3240 Mank (AT)
(74) Vertreter: Patentanwaltskanzlei Matschnig & Forsthuber OG
(86) Internationale Anmeldenummer: PCT/AT2015/050016
(87) Internationale Veröffentlichungsnummer: WO 2015/106303

(56) Entgegenhaltungen:
- EP-A1- 1 359 450
- EP-A2- 2 525 140
- EP-A2- 2 537 708
- WO-A1-2013/146749
- JP-A- 2012 109 201
- US-A1- 2006 139 918
- US-A1- 2007 097 501
- US-A1- 2009 046 474
- US-A1- 2009 207 626
- US-B1- 6 198 580

## Beschreibung

Die Erfindung betrifft eine Lasereinheit für einen Fahrzeugscheinwerfer sowie ein entsprechendes Lasermodul.

Im Stand der Technik sind verschiedene Arten von Fahrzeugscheinwerfern bekannt, wobei in den letzten Jahren überwiegend Scheinwerfer mit Entladungslampen und Halogen-Lichtquellen verwendet wurden. Aus Energiespargründen und um den Platzbedarf von Fahrzeugscheinwerfern weiter zu verringern, wird zunehmend der Einsatz von Laserlichtquellen wie Halbleiterlasern erprobt, da diese diesbezüglich von Vorteil sind. Um das Laserlicht für einen Fahrzeugscheinwerfer nutzbar zu machen, wird dabei mit einer Laserlichtquelle ein Lichtkonversionsmittel, ein sogenannter Phosphor-Konverter, bestrahlt, der dadurch zur Abstrahlung von sichtbarem Licht angeregt wird.

Bei sogenannten statischen Systemen wird der Laserstrahl unbeweglich auf den Phosphor-Konverter gerichtet. Demgegenüber werden bei den sogenannten dynamischen System der Laserstrahl bzw. die Laserstrahlen, die zur Anregung des Phosphor-Konverters verwendet werden, mit Hilfe von oszillierenden Spiegeln über den Phosphor-Konverter bewegt, sodass für das Auge ein Lichtbild entsteht, welches der äußeren Form des Phosphor-Konverters entspricht. Durch geeignete Formgebung des Phosphor-Konverters können bestimmte Lichtfunktionen bzw. präzise Hell-Dunkel-Grenzen der Lichtfunktionen wie beispielsweise Fernlicht, Abblendlicht und dergleichen erzielt werden.

Beispielsweise zeigt die US 2011/0194302 A1 eine Lasereinheit, bei der eine Laserdiode von hinten über ein Lichtleitelement auf eine fluoreszierende Substanz strahlt, die dann ihrerseits sichtbares Licht emittiert, das über einen Reflektorschirm in Fahrtrichtung gelenkt wird. Die dabei zum Einsatz kommenden Laserlichtquellen emittieren Energien bis zu 3 W in Hauptabstrahlrichtung des Scheinwerfers. Im Falle einer Fehlfunktion oder Beschädigung des Scheinwerfers kann es also durch hochintensive augenschädigende Laser-Lichtstrahlung zu Verletzungen, jedenfalls aber zur Gefährdung anderer Verkehrsteilnehmer kommen.

Die EP 2 525 140 A2 zeigt eine Lasereinheit für einen Fahrzeugscheinwerfer mit einer Laserdiode und einer der Laserdiode zugeordneten, einstellbaren Optik mit optischen Elementen. Die Lasereinheit kann dabei eine ungleichmäßige Farbverteilung der Lichtverteilung unterdrücken.

Wesentlich für eine einwandfreie und sichere Funktion eines solchen Lasersystems in einem Fahrzeugscheinwerfer ist daher die präzise Ausrichtung des Laserstrahls bzw. der Laserstrahlen auf den oder die Lichtkonversionsmittel bzw. den oder die Spiegel und in der Folge auf den Phosphor-Konverter, wobei dies durch einstellbare Optik, die das von der Laserdiode ausgesendete Licht auf einen Umlenkspiegel leitet, bewerkstelligt wird. Beispielsweise beträgt der Durchmesser eines oszillierenden Spiegels nur wenige Millimeter, deshalb ist es vor allem bei Verwendung von mehreren Laserstrahlen zur Anregung des Lichtkonversionsmittels von größter Wichtigkeit, die Laser exakt zu dem Spiegel auszurichten. Die Justierung der einstellbaren Optik muss in der Regel für jeden Laser einzeln vorgenommen werden, da aufgrund von Produktionstoleranzen des Lasers und der optischen Elemente der einstellbaren Optik und deren Festlegung an einem entsprechenden Montageelement eine Voreinstellung, die den Anforderungen bezüglich der Genauigkeit der Ausrichtung entspricht, nicht möglich ist.

Im Stand der Technik wurden hierfür bereits Lösungen vorgeschlagen, bei denen eine Kollimatorlinse einer Lasereinheit mit Hilfe eines Linsenhalters in einer entsprechenden Lagerplatte festgeklebt wurde, wobei dieses Verfahren jedoch in der Massenproduktion einen großen Aufwand und insbesondere ein gewisses handwerkliches Geschick bei der Montage erfordert. Darüber hinaus ist es schwierig, bei der Verwendung von mehreren Lasereinheiten zur Anregung eines Phosphor-Konverters, eine optimale Abstimmung der einzelnen Laserstrahlen aufeinander zu erzielen, wenn der verwendete Klebstoff einmal ausgehärtet ist, da eine Nachjustierung nicht ohne Weiteres möglich ist.

Der Erfindung liegt daher die Aufgabe zugrunde, eine Lasereinheit anzugeben, bei der die Einstellung der einer Laserdiode zugeordneten einstellbaren Optik bzw. deren optischer Elemente einfach und präzise erfolgen kann und eine endgültige Fixierung der Position der Linse erst in einem der Einstellung nachgeordneten Montage- bzw. Verfahrensschritt erfolgen kann.

Diese Aufgabe wird durch eine Lasereinheit der eingangs genannten Art gelöst, wobei zumindest eines der optischen Elemente, ausgewählt aus der Gruppe bestehend aus einem Kollimator, welcher als eine in einem Halteelement gelagerte, optische Kollimatorlinse oder als ein in dem Halteelement gelagerter Parabolspiegel ausgebildet ist, und einem Umlenkspiegel, welcher an dem Halteelement festgelegt ist, durch das Halteelement um zumindest eine Raumachse schwenkbar gelagert ist, wobei das Halteelement einen Aufnahmeteil für den Kollimator oder für den Umlenkspiegel und jeweils einen an dem Aufnahmeteil angreifenden Hebel zur Verschwenkung des Halteelements aufweist.

Die Lasereinheit mit der Laserdiode und der einstellbaren Optik kann in bzw. an einem Scheinwerfer festgelegt werden, wobei es die schwenkbare Festlegung der erfindungsgemäß definierten optischen Elemente gestattet, nach einer Montage der Lasereinheit den Laserstrahl der Lasereinheit genau zu justieren, sodass der Laserstrahl den Phosphor-Konverter exakt wie zuvor berechnet trifft und somit geeignet zum Fluoreszieren bringt. Dadurch, dass zumindest eines der erfindungsgemäß definierten optischen Elemente um zumindest eine Raumachse schwenkbar gelagert ist, kann die Justierung der einstellbaren Optik bequem nach dem Zusammenbau der wesentlichen Teile des Fahrzeugscheinwerfers erfolgen, wodurch das handwerkliche Geschick, das zum Justieren der Linse notwendig ist, relativ gering ist.

Bevorzugt ist der Kollimator als eine in einem Halteelement gelagerte, optische Kollimatorlinse ausgebildet, wobei das Halteelement um zumindest eine Raumachse schwenkbar gelagert ist. In diesem bevorzugten Fall erfolgt die Justierung der einstellbaren Optik über die Verstellung einer der Laserdiode zugeordneten Kollimatorlinse, wobei der Laserstrahl in der Folge direkt oder unter Zwischenschaltung eines oder mehrerer optischer Elemente und gegebenenfalls eines oszillierenden Spiegels auf den Phosphor-Konverter treffen kann. Im Rahmen der vorliegenden Erfindung kann unter einer Kollimatorlinse auch ein System aus mehreren Linsen verstanden werden, wobei eine Mehrzahl von Linsen bei einem Kollimator zur Korrektur von Abbildungs- bzw. Farbfehlern dient.

Gemäß einer anderen bevorzugten Ausführungsform ist der Kollimator als ein in einem Halteelement gelagerter Parabolspiegel ausgebildet, wobei das Halteelement um zumindest eine Raumachse schwenkbar gelagert. In diesem bevorzugten Fall erfolgt die Justierung der einstellbaren Optik über die Verstellung eines der Laserdiode zugeordneten Parabolspiegels, der als Kollimator fungiert, wobei der Laserstrahl in der Folge direkt oder unter Zwischenschaltung eines oder mehrerer optischer Elemente und gegebenenfalls eines oszillierenden Spiegels auf den Phosphor-Konverter treffen kann.

Eines der oben genannten gegebenenfalls zwischengeschalteten optischen Elemente kann wie bereits definiert, ein Umlenkspiegel der einstellbaren Optik sein, wobei es gemäß einer bevorzugten Ausführungsform der vorliegenden Erfindung vorgesehen sein kann, dass der Umlenkspiegel an einem um zumindest eine Raumachse schwenkbar gelagerten Halteelement festgelegt ist.

Gemäß einer besonders bevorzugten Ausführungsform der vorliegenden Erfindung ist der Kollimator auf den Umlenkspiegel gerichtet und das Halteelement für den Kollimator ist um zumindest eine Raumachse schwenkbar gelagert.

Um eine besonders flexible Einstellung der Optik zu gewährleisten, ist die Erfindung mit Vorteil dahingehend weitergebildet, dass das Halteelement um zwei Raumachsen schwenkbar gelagert ist. Bei dieser bevorzugten Ausführungsform kann das von der Laserdiode abgestrahlte Licht sowohl nach der Höhe als auch nach der Seite gelenkt werden, sodass sämtliche Ungenauigkeiten ausgeglichen werden können.

Im Kontext der vorliegenden Erfindung ist es vorgesehen, dass die Kollimatorlinse im Bereich von +/- 3° ausgehend von einer Neutralstellung um die jeweilige Raumachse schwenkbar ist, was für den Ausgleich von Fertigungstoleranzen der einzelnen Elemente einer Lasereinheit ausreichend sein sollte.

Zur einfachen Verstellbarkeit des Linsenhalters und damit der Linse ist die Erfindung dahingehend weitergebildet, dass das Halteelement einen Aufnahmeteil für den Kollimator bzw. für den Umlenkspiegel und jeweils einen an dem Aufnahmeteil angreifenden Hebel zur Verschwenkung des Halteelements um jeweils eine Raumachse aufweist. Die Richtung, in die der Hebel auskragt, und der Drehpunkt der schwenkbaren Festlegung des Halteelements definieren eine Schwenkachse, die senkrecht zu dem Hebel verläuft. Durch Betätigen des Hebels erfolgt die Verschwenkung des Halteelements und damit des Kollimators bzw. des Umlenkspiegels um die so definierte Raumachse.

Bevorzugt ist die Erfindung dahingehend weitergebildet, dass das Halteelement zwei an dem Aufnahmeteil angreifende Hebel zur Verschwenkung des Halteelements um zwei zueinander in einem rechten Winkel stehende Raumachsen aufweist, wodurch durch Betätigen der Hebel die Einstellung des Laserstrahls in Höhenrichtung und in Seitenrichtung einfach und schnell bewerkstelligt werden kann.

Unabhängig davon, ob an dem Aufnahmeteil für die Linse nun lediglich ein Hebel oder zwei Hebel angreifen, kann die Lasereinheit gemäß einer bevorzugten Ausführungsform dahingehend weitergebildet sein, dass der Aufnahmeteil und der/die Hebel einstückig miteinander ausgebildet ist/sind. Im einfachsten Fall sind die genannten Elemente hierbei als Spritzgussteile ausgebildet.

Eine besonders günstige Ausgestaltung der vorliegenden Erfindung liegt dann vor, wenn jeweils ein elastisch verformbares Federelement zwischen einem Hebel und einem Montageelement für das Halteteil angeordnet ist und dass der/die Hebel jeweils von einer Stellschraube gegen das Montageelement pressbar ist/sind. Durch die Anordnung eines verformbaren Federelements zwischen einem Hebel und dem Montageelement nimmt der Hebel eine definierte Lage gegen die jeweilige Stellschraube ein und kann durch Betätigen der Stellschraube gegen das verformbare, insbesondere elastische, Auflager bzw. Federelement gedrückt werden. Bei entsprechender Wahl der Dicke des Federelements kann die geforderte Verschwenkbarkeit des Kollimators bzw. des Halteelements um die jeweilige Raumachse sichergestellt werden, wobei durch die Federwirkung des Federelements jederzeit eine Rückstellung des Hebels gewährleistet ist, wenn dies für eine spätere Nachjustierung notwendig sein sollte.

Gemäß einer bevorzugten Ausführungsform der vorliegenden Erfindung wirken der/die Hebel bzw. die jeweilige/n Stellschraube/n unter Vermittlung einer kugeligen Ausformung zusammen. Eine solche kugelige Ausformung sorgt für eine gute Kraftübertragung unabhängig vom Grad der Verschwenkung des Aufnahmeteils und kann mit gleicher Wirkung an der Stellschraube oder am Hebel ausgeformt sein.

Eine besonders günstige Konfiguration der erfindungsgemäßen Lasereinheit wird dann erreicht, wenn die Stellschraube/ die Stellschrauben drehbar in einer auf dem Montageelement festgelegten Lagerplatte aufgenommen ist/sind, wie dies einer bevorzugten Ausführungsform der vorliegenden Erfindung entspricht. Neben der Lagerung der Stellschrauben gestattet das Vorsehen einer derartigen Lagerplatte auch die schwenkbare Festlegung des Halteelements mit den Hebeln, wenn dieser in eine entsprechende Ausnehmung im Montageelement eingesetzt und dann mit Hilfe der Lagerplatte abgedeckt wird. Nach dem Festlegen der Lagerplatte, beispielsweise durch Schrauben oder Kleben, sind sämtliche bewegliche Teile der erfindungsgemäßen Lasereinheit zusammengefasst und können am Scheinwerfer montiert werden.

Um eine dauerhafte Fixierung der eingestellten Position des Halteelements bzw. der erfindungsgemäß definierten optischen Elemente zu gewährleisten, ist die Erfindung bevorzugt dahingehend weitergebildet, dass die Stellschraube/die Stellschrauben drehfest festlegbar ist/sind, wodurch die dauerhafte Festlegung auch ohne ein abschließendes Verkleben des Linsenhalters möglich wird. In bevorzugter Weise ist die Erfindung hierbei dahingehend weitergebildet, dass die Stellschraube/ die Stellschrauben jeweils mittels einer Kontermutter drehfest festlegbar ist/sind.

Zusätzlich ist es natürlich weiterhin denkbar, dass das Halteelement mit einer Verklebung festgelegt ist, wie dies einer bevorzugten Ausführungsform der vorliegenden Erfindung entspricht.

Die Laserdioden sind Hochleistungsbauelemente, die beim Betrieb in Fahrzeugscheinwerfern große Wärmemengen produzieren. Aus diesem Grund müssen im Normalfall mit dem verwendeten Laserdioden Kühlvorrichtungen assoziiert sein, um die großen und punktuell auftretenden Wärmemengen zu verteilen und abzuleiten. Die Erfindung ist daher bevorzugt dahingehend weitergebildet, dass ein Kühlkörper auf der Lagerplatte festgelegt ist, der Ausnehmungen für die Stellschraube/ die Stellschrauben aufweist, was einen großflächigen Kontakt des Kühlkörpers mit den zur Erhitzung neigenden Bauteilen ermöglicht, wobei jedoch die Einstellbarkeit des Linsenhalters bzw. der Kollimatorlinse durch die Stellschrauben nicht beeinträchtigt wird.

Während die Erfindung unter Bezugnahme auf eine Lasereinheit bestehend aus einer Laserdiode einer der Laserdiode zugeordneten, einstellbaren Optik mit optischen Elementen beschrieben wurde, wird es dem Fachmann geläufig sein, dass derartige Lasereinheiten in aller Regel zu einem Lasermodul umfassend eine Mehrzahl von derartigen Lasereinheiten zusammengefasst werden.

Gemäß einer bevorzugten Ausführungsform der vorliegenden Erfindung umfasst ein derartiges Lasermodul drei erfindungsgemäße Lasereinheiten, wobei die Montageeinheiten der Lasereinheiten zu einem gemeinsamen Strahlengang zusammengefasst sind, in dem Umlenkspiegel festgelegt sind.

Die Erfindung wird nachfolgend anhand eines in der Zeichnung schematisch dargestellten Ausführungsbeispiels näher erläutert. In dieser zeigen
- Figur 1: eine perspektivische Gesamtansicht wesentlicher Teile eines Fahrzeugscheinwerfers mit einer Mehrzahl von erfindungsgemäßen Lasereinheiten,
- Figur 2: eine Draufsicht auf das erfindungsgemäße Lasermodul der Fig. 1 mit drei Lasereinheiten,
- Figur 3: eine Schnittdarstellung des erfindungsgemäßen Lasermoduls der Fig. 2 nach der Linie A - A,
- Figur 4: eine Schnittdarstellung einer erfindungsgemäßen Lasereinheit gemäß einer bevorzugten Ausführungsform,
- Figur 5: eine Schnittdarstellung einer erfindungsgemäßen Lasereinheit gemäß einer weiteren bevorzugten Ausführungsform,
- Figur 6: eine Schnittdarstellung einer erfindungsgemäßen Lasereinheit gemäß einer weiteren bevorzugten Ausführungsform,
- Figur 7: eine perspektivische Darstellung eines Halteelements gemäß der vorliegenden Erfindung,
- Figuren 8a und 8b: weitere Schnittdarstellungen einer bevorzugten Ausführungsform der vorliegenden Erfindung und
- Figur 9: ein Detail einer alternativen Ausführungsform der vorliegenden Erfindung.

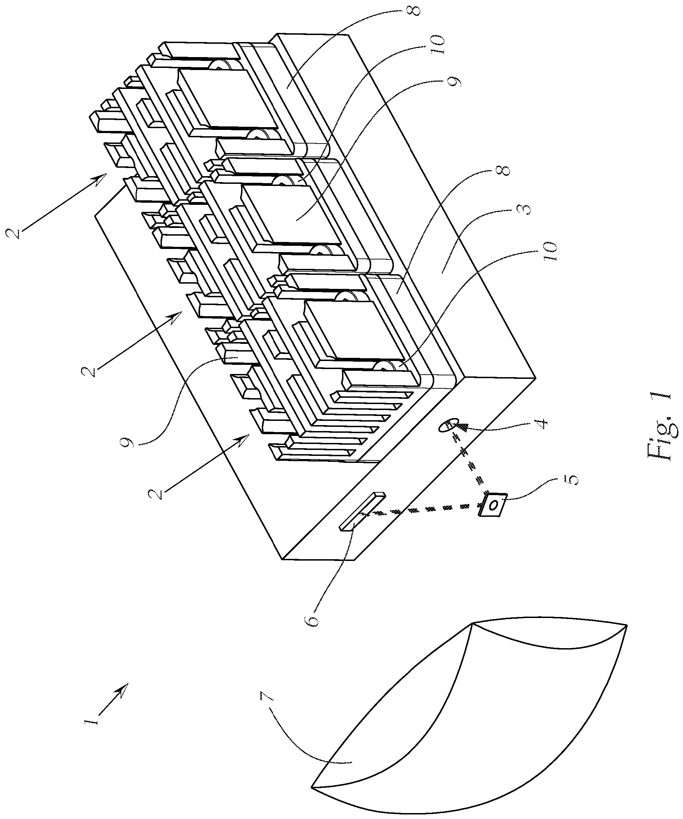

In Fig. 1 ist mit 1 ein Lasermodul eines der Übersichtlichkeit halber nicht dargestellten Fahrzeugscheinwerfers bezeichnet. Das Lasermodul 1 verfügt im vorliegenden, bevorzugten Fall über drei Lasereinheiten 2, deren Montageeinheiten 3 zusammengefasst sind und einen gemeinsamen Strahlengang 4 bilden. Bei dem erfindungsgemäßen Lasermodul 1 strahlt jede Lasereinheit 2 Laserlicht aus, welches aus dem Strahlengang 4 austritt. Das Laserlicht kann über einen ggf. oszillierend gelagerten Spiegel 5 auf einen Phosphor-Konverter bzw. ein Lichtkonversionsmittel 6 geleitet werden, der dadurch zur Abstrahlung von sichtbarem Licht angeregt wird. Dieses sichtbare Licht kann mittels einer Linse 7 auf eine nicht dargestellte Strasse projiziert werden. Projiziert wird hierbei ein vom Laser auf das Lichtkonversionsmittel aufgezeichnetes Lichtbild. Neben einem solchen dynamischen System sind auch statische Systeme üblich, die weiter unten im Zusammenhang mit weiteren Figuren besprochen werden.

Die Lasereinheiten 2 weisen neben den Montageeinheiten 3 jeweils eine Lagerplatte 8 und jeweils einen darauf festgelegten Kühlkörper 9 auf, der die Wärme, die von den Laserdioden 11 herrührt, an die Umgebung ableiten kann. Die Festlegung der Kühlkörper 9 erfolgt mit Hilfe von Schrauben 10, die in entsprechenden Ausnehmungen am Kühlkörper 9 aufgenommen sind.

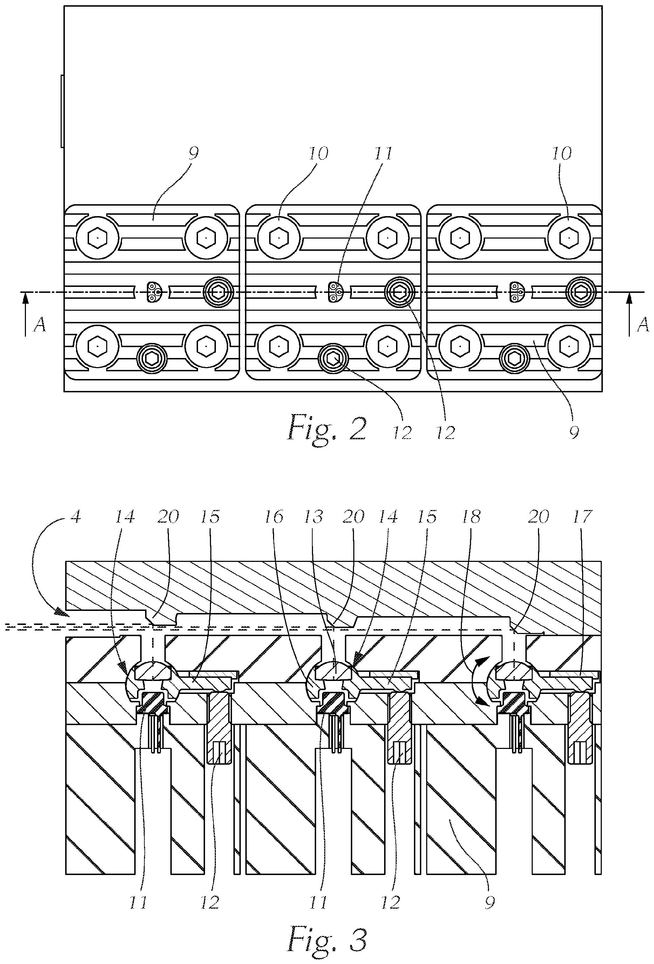

In der Draufsicht der Fig. 2 sind erneut die Kühlkörper 9 sowie die Schrauben 10 erkennbar. In dieser Darstellung lassen sich die Laserdioden 11 erkennen, die in diesem Beispiel mit Hilfe der Stellschrauben 12 um zwei zueinander in einem rechten Winkel stehende Raumachsen schwenkbar gelagert sind.

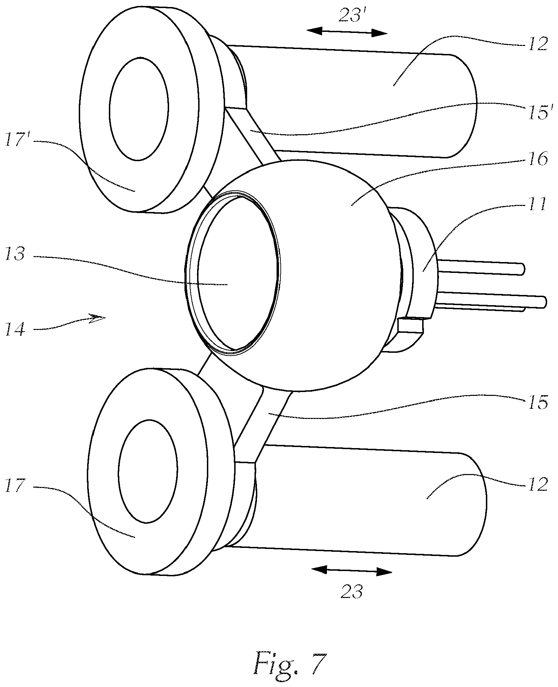

In der Schnittdarstellung der Fig. 3 ist nun zu erkennen, dass jeder Laserdiode 11 ein Kollimator, im vorliegenden Fall in Form einer Kollimatorlinse 13, als Teil einer einstellbaren Optik zugeordnet ist. Die Kollimatorlinse 13 ist in einem Halteelement 14 gelagert, welches mittels des Hebels 15, der einstückig mit einem Aufnahmeteil 16 ausgebildet ist und der durch Anziehen und Lösen der Stellschraube 12 gegen die Federwirkung des elastischen Federelements 17 in Richtung des Doppelpfeils 18 verschwenkt werden kann. Typischerweise kann eine Verschwenkung um +/-3° herbeigeführt werden, wobei der Grad der Verschwenkung durch den Fachmann durch einfache handwerkliche Maßnahmen den Bedürfnissen entsprechend angepasst werden kann. In diesem Schnitt nicht dargestellt, jedoch in Zusammenschau mit den vorhergehenden Figuren für den Fachmann erkennbar, ist ein weiterer Hebel 15' (Fig. 7) im rechten Winkel zum Hebel 15 am Halteelement 14 angeordnet, und sorgt in gleicher Weise wie der Hebel 15 um eine Verschwenkung des Halteelements 14. Das Halteelement 14 bzw. Halteelemente 14 sind zwischen einem Montageelement 3 und einer Lagerplatte 8 schwenkbar gelagert, wobei die Stellschrauben 12 drehbar in der Lagerplatte 8 aufgenommen sind und in nicht näher dargestellter Weise drehfest festgelegt werden können. Nach dem Kollimator 13, der erfindungsgemäß einstellbar ist, kann das Licht mit Hilfe eines feststehenden Umlenkspiegels 20 umgelenkt werden, um in der Folge aus dem Strahlengang 4 auszutreten. Im vorliegenden Beispiel werden drei Laserstrahlen eingesetzt, die nach dem sogenannten "Knife Edge Combining-Verfahren" möglichst nahe beieinander und exakt parallel zueinander ausgerichtet werden müssen, um am Lichtkonversionsmittel ein homogenes Lichtbild abzubilden. Dies erfordert klarerweise eine hohe Präzision der Einstellung des optischen Systems.

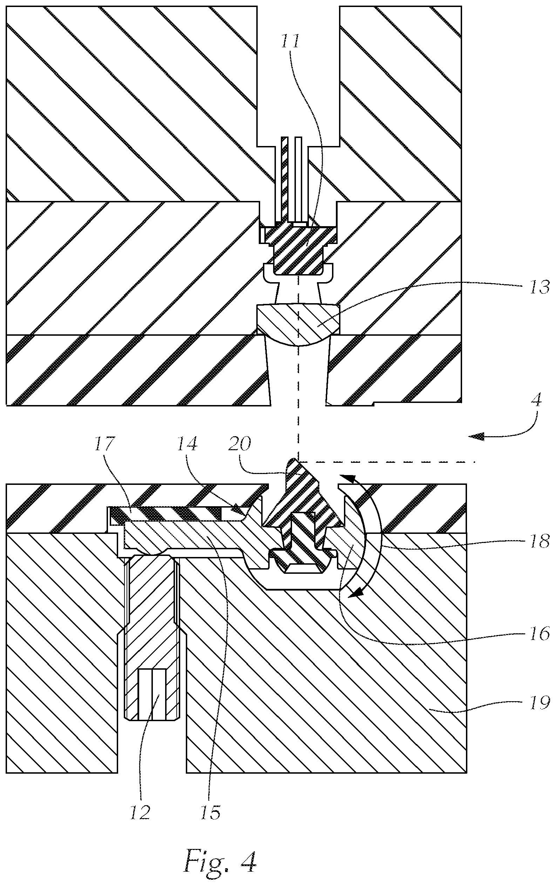

Gemäß der in Fig. 4 dargestellten bevorzugten Variante der vorliegenden Erfindung kann anstatt des Kollimators 13 auch der Umlenkspiegel 20 um zwei Raumachsen verschwenkbar gelagert sein, wobei in dieser Figur gleichwirkende Teile mit gleichen Bezugszeichen versehen wurden. Der Umlenkspiegel 20 kann hierbei auch einstückig mit dem Aufnahmeteil 16 ausgebildet bzw. in dieses eingegossen sein.

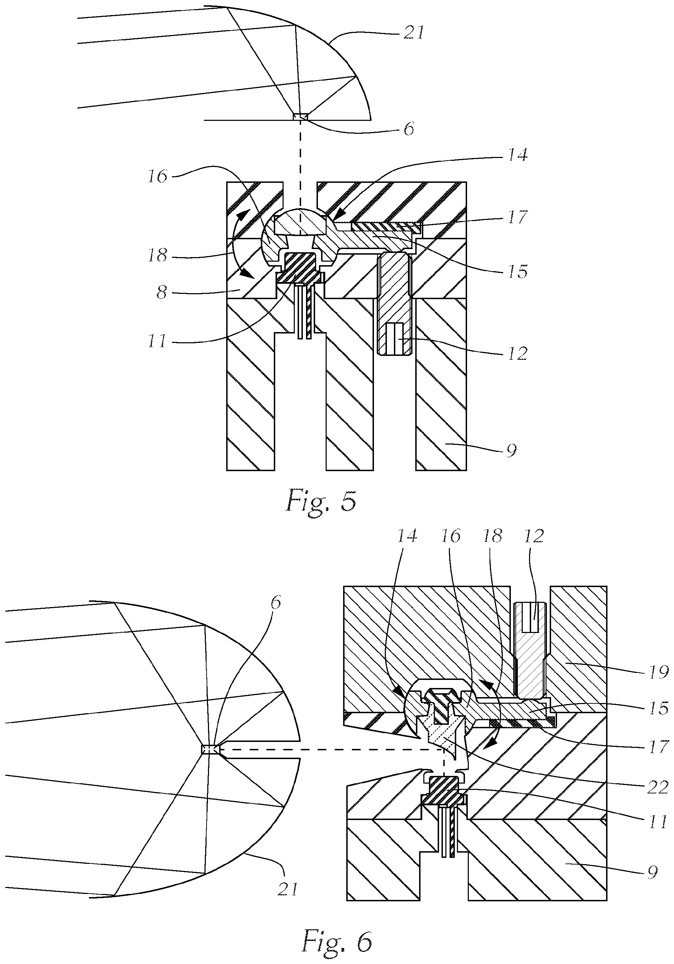

Bei der erfindungsgemäßen, bevorzugten Variante gemäß Fig. 5 sind weder Strahlengang noch Umlenkspiegel vorgesehen und das Licht der Laserdiode 11 wird direkt auf den Phosphor-Konverter 6 gerichtet, welcher das Laserlicht teilweise konvertiert und so eine weiße Lichtquelle für das anschließende optische System zur Verfügung stellt. Das optische System kann, wie in Fig. 5 gezeigt, ein Reflektor aber auch eine Linse oder eine Kombination dieser Elemente sein. Auch hier sind gleichwirkende Teile mit gleichen Bezugszeichen versehen.

Fig. 6 zeigt eine erfindungsgemäße und bevorzugte Variante, bei der die einstellbare Optik von einem Parabolspiegel 22 gebildet ist, der in der beschriebenen Art und Weise verschwenkbar gelagert ist. Hier erfolgt somit die Kollimierung des divergenten Laserlichts über einen Parabolspiegel 22, wobei dieser Parabolspiegel 22 mit einer Kollimatorlinse oder einem anderen optischen Element bzw. System zusammenwirken kann, um nach der Kollimierung eine Fokussierung des Laserlichts zu bewerkstelligen. Beispielsweise wäre eine Kombination mit einem hyperbolischen Spiegel und einer entsprechend ausgelegten Linse denkbar, um somit den Bauraumbedarf zu verringern.

Fig. 7 zeigt das Halteelement 14 mit dem Kollimator 13, der Laserdiode 11 und den beiden Hebeln 15 und 15' sowie zwei verformbaren Federelement 17 und 17'. Es ist zu erkennen, dass die beiden Hebel 15 und 15' in einem rechten Winkel zueinander stehen und an dem Aufnahmeteil 16 angreifen und im vorliegenden Fall einstückig mit diesem ausgebildet sind. Die Stellschrauben 12 vermögen die Hebel in Richtung der Doppelpfeile 23 bzw. 23' zu drücken, dies gegen den Widerstand der verformbaren Federelemente 17 bzw. 17', sodass eine reversible Verschwenkung des Halteelements 14 und somit des Kollimators 13 erfolgt.

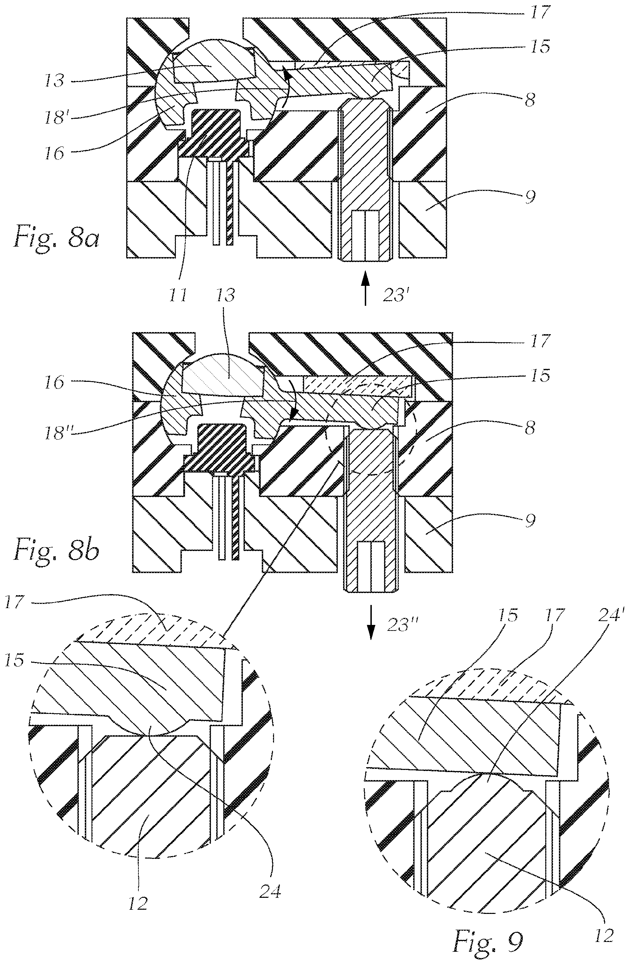

In den Figuren 8a und 8b ist die Verschwenkung des Aufnahmeteils 16 noch einmal verdeutlicht. Bei einem Hineinschrauben der Stellschraube in Richtung des Pfeils 23' (Fig. 8a) wird der Hebel 15 unter Stauchung des Federelements 17 bewegt, was zu einer Verschwenkung des Aufnahmeteils 16 und somit des Kollimators 13 im Sinne des Pfeils 18' erfolgt. Andererseits erfolgt durch die Federwirkung des Federelements 17 eine Verschwenkung des Aufnahmeteils 16 bzw. des Kollimators 13 im entgegengesetzten Sinn, d.h. im Sinne des Pfeils 18", wenn die Stellschraube 12 im Sinne des Pfeils 23" herausgeschraubt wird. In der Detailansicht der Fig. 8b ist deutlich zu erkennen, dass der Hebel 15 eine kugelige Ausformung 24 aufweist, um eine optimale Kraftübertragung von der Stellschraube 12 auf den Hebel 15 zu gewährleisten. Klarerweise kann eine kugelige Ausformung 24' auch an der Stellschraube 12 vorgesehen sein, wie dies in Fig. 9 dargestellt ist, um denselben Effekt einer guten Kraftübertragung von der Stellschraube 12 auf den Hebel 15 zu erzielen.

## Patentansprüche

1. Lasereinheit für einen Fahrzeugscheinwerfer mit einer Laserdiode und einer der Laserdiode zugeordneten, einstellbaren Optik mit optischen Elementen umfassend zumindest einen Kollimator, **dadurch gekennzeichnet, dass**
zumindest eines der optischen Elemente, ausgewählt aus der Gruppe bestehend aus einem Kollimator (13, 22), welcher als eine in einem Halteelement (14) gelagerte, optische Kollimatorlinse (13) oder als ein in dem Halteelement (14) gelagerter Parabolspiegel (22) ausgebildet ist, und einem Umlenkspiegel (20), welcher an dem Halteelement (14) festgelegt ist, durch das Halteelement (14) um zumindest eine Raumachse schwenkbar gelagert ist, wobei das Halteelement (14) einen Aufnahmeteil (16) für den Kollimator (13, 22) oder für den Umlenkspiegel (20) und jeweils einen an dem Aufnahmeteil (16) angreifenden Hebel (15, 15') zur Verschwenkung des Halteelements (14) aufweist.

2. Lasereinheit nach Anspruch 1, **dadurch gekennzeichnet, dass** der Kollimator (13, 22) auf einen Umlenkspiegel (20) bzw. auf den schwenkbar gelagerten Umlenkspiegel (20) gerichtet ist.

3. Lasereinheit nach einem der Ansprüche 1 oder 2, **dadurch gekennzeichnet, dass** das Halteelement (14) um zwei Raumachsen schwenkbar gelagert ist.

4. Lasereinheit nach einem der Ansprüche 1 bis 3, **dadurch gekennzeichnet, dass** das Halteelement (14) um zwei zueinander in einem rechten Winkel stehende Raumachsen schwenkbar gelagert ist.

5. Lasereinheit nach einem der Ansprüche 1 bis 4, **dadurch gekennzeichnet, dass** das Halteelement (14) zwei an dem Aufnahmeteil angreifende Hebel (15, 15') zur Verschwenkung des Halteelements (14) um zwei zueinander in einem rechten Winkel stehende Raumachsen aufweist.

6. Lasereinheit nach einem der Ansprüche 1 bis 5, **dadurch gekennzeichnet, dass** der Aufnahmeteil (16) und der/die Hebel (15,15') einstückig miteinander ausgebildet sind.

7. Lasereinheit nach einem der Ansprüche 1 bis 6, **dadurch gekennzeichnet, dass** jeweils ein elastisch verformbares Federelement (17) zwischen einem Hebel (15, 15') und einem Montageelement (3) für das Halteteil (14) angeordnet ist und dass der/die Hebel (15, 15') jeweils von einer Stellschraube (12) gegen das Montageelement (3) pressbar ist/sind.

8. Lasereinheit nach Anspruch 7, **dadurch gekennzeichnet, dass** der/die Hebel (15, 15') bzw. die jeweilige/n Stellschraube/n unter Vermittlung einer kugeligen Ausformung (24, 24') zusammenwirken.

9. Lasereinheit nach Anspruch 7 oder 8, **dadurch gekennzeichnet, dass** die Stellschraube/die Stellschrauben (12) drehbar in einer auf dem Montageelement (3) festgelegten Lagerplatte (19) aufgenommen ist/sind und vorzugsweise ein Kühlkörper (9) auf der Lagerplatte (19) festgelegt ist, der Ausnehmungen für die Stellschraube/die Stellschrauben (12) aufweist.

10. Lasereinheit nach einem der Ansprüche 7 bis 9, **dadurch gekennzeichnet, dass** die Stellschraube/die Stellschrauben (12) drehfest festlegbar ist/sind.

11. Lasereinheit nach einem der Ansprüche 7 bis 10, **dadurch gekennzeichnet, dass** die Stellschraube/die Stellschrauben (12, 12') jeweils mittels einer Kontermutter zu einer dauerhaften Fixierung einer eingestellten Position drehfest festlegbar sind.

12. Lasereinheit nach einem der Ansprüche 1 bis 11, **dadurch gekennzeichnet, dass** das Halteelement (14) zu einer dauerhaften Fixierung einer eingestellten Position mit einer Verklebung festgelegt ist.

13. Lasermodul (1) umfassend eine Mehrzahl von Lasereinheiten (2) gemäß einem der Ansprüche 1 bis 11.

14. Lasermodul (1) nach Anspruch 13 umfassend drei Lasereinheiten (2) nach einem der Ansprüche 1 bis 12, wobei die Montageeinheiten der Lasereinheiten zu einem gemeinsamen Strahlengang zusammengefasst sind, in dem Umlenkspiegel festgelegt sind.

## Claims

1. A laser unit for a vehicle headlamp, comprising a laser diode and an adjustable optical system, which is associated with the laser diode and has optical elements comprising at least one collimator, **characterised in that**
at least one of the optical elements, selected from the group consisting of a collimator (13, 22), which is formed as an optical collimator lens (13) mounted in a retaining element (14) or as a parabolic mirror (22) mounted in the retaining element (14), and a deflection mirror (20), which is fixed to the retaining element (14), is mounted pivotably about at least one spatial axis by means of the retaining element (14), wherein the retaining element (14) comprises a receiving part (16) for the collimator (13, 22) or for the deflection mirror (20) and in each case a lever (15, 15') acting on the receiving part (16) to pivot the retaining element (14).

2. The laser unit according to claim 1, **characterised in that** the collimator (13, 22) is directed towards a deflection mirror (20) or to the pivotably mounted deflection mirror (20).

3. The laser unit according to any one of claims 1 or 2, **characterised in that** the retaining element (14) is mounted pivotably about two spatial axes.

4. The laser unit according to any one of claims 1 to 3, **characterised in that** the retaining element (14) is mounted pivotably about two spatial axes arranged at right angles to one another.

5. The laser unit according to any one of claims 1 to 4, **characterised in that** the retaining element (14) comprises two levers (15, 15') acting on the receiving part to pivot the retaining element (14) about two spatial axes arranged at right angles to one another.

6. The laser unit according to any one of claims 1 to 5, **characterised in that** the receiving part (16) and the lever(s) (15, 15') are integrally formed.

7. The laser unit according to any one of claims 1 to 6, **characterised in that** a resiliently deformable spring element (17) is arranged between each lever (15, 15') and a mounting element (3) for the retaining part (14), and **in that** the lever(s) (15, 15') in each case can be pressed against the mounting element (3) by an adjusting screw (12).

8. The laser unit according to claim 7, **characterised in that** the lever(s) (15, 15') and the corresponding adjusting screw(s) interact with one another through a spherically shaped part (24, 24').

9. The laser unit according to claim 7 or 8, **characterised in that** the adjusting screw/the adjusting screws (12) is/are received rotatably in a support plate (19) fixed to the mounting element (3), and preferably a heat sink (9) is fixed on the support plate (19) and comprises recesses for the adjusting screw/the adjusting screws (12).

10. The laser unit according to any one of claims 7 to 9, **characterised in that** the adjusting screw/the adjusting screws (12) can be fixed non-rotatably.

11. The laser unit according to any one of claims 7 to 10, **characterised in that** the adjusting screw/the adjusting screws (12, 12') can be fixed non-rotatably by means of a respective lock nut so as to provide a permanent fixing of a set position.

12. The laser unit according to any one of claims 1 to 11, **characterised in that** the retaining element (14) is fixed by means of adhesive bonding so as to provide a permanent fixing of a set position.

13. A laser module (1) comprising a plurality of laser units (2) according to any one of claims 1 to 11.

14. The laser module (1) according to claim 13, comprising three laser units (2) according to any one of claims 1 to 12, wherein the mounting units of the laser units are combined to form a common beam path, in which deflection mirrors are fixed.

## Revendications

1. Unité laser pour un phare de véhicule, pourvue d'une diode laser et d'un système optique réglable associé à la diode laser et comportant des éléments optiques qui comprennent au moins un collimateur, **caractérisée par le fait que**
au moins un des éléments optiques, choisi dans le groupe consistant en un collimateur (13, 22), lequel est réalisé en tant que lentille de collimateur optique, montée dans un élément de retenue (14), ou en tant que miroir parabolique (22) monté dans l'élément de retenue (14), et un miroir de déviation (20), lequel est fixé sur l'élément de retenue (14), est monté pivotant autour d'au moins un axe spatial par l'élément de retenue (14), l'élément de retenue (14) présentant une partie réceptacle (16) pour le collimateur (13, 22) ou pour le miroir de déviation (20) et respectivement un levier (15, 15') agissant sur la partie réceptacle (16) pour le pivotement de l'élément de retenue (14).

2. Unité laser selon la revendication 1, **caractérisée par le fait que** le collimateur (13, 22) est dirigé sur un miroir de déviation (20) ou sur le miroir de déviation (20) monté pivotant.

3. Unité laser selon l'une des revendications 1 ou 2, **caractérisée par le fait que** l'élément de retenue (14) est monté pivotant à pivoter autour de deux axes spatiaux.

4. Unité laser selon l'une des revendications 1 à 3, **caractérisée par le fait que** l'élément de retenue (14) est monté pivotant autour de deux axes spatiaux qui sont à angles droits l'un par rapport à l'autre.

5. Unité laser selon l'une des revendications 1 à 4, **caractérisée par le fait que** l'élément de retenue (14) présente deux leviers (15, 15') agissant sur la partie réceptacle pour le pivotement de l'élément de retenue (14) autour de deux axes spatiaux à angles droits l'un par rapport à l'autre.

6. Unité laser selon l'une des revendications 1 à 5, **caractérisée par le fait que** la partie réceptacle (16) et le(s) levier(s) (15, 15') sont formés d'une seule pièce.

7. Unité laser selon l'une des revendications 1 à 6, **caractérisée par le fait que** respectivement un élément de ressort élastiquement déformable (17) est disposé entre un levier (15, 15') et un élément de montage (3) pour l'élément de retenue (14) et que le (s) levier (s) (15, 15') est (sont) aptes à être pressés respectivement contre l'élément de montage (3) par une vis de réglage (12).

8. Unité laser selon la revendication 7, **caractérisée par le fait que** le (s) levier (s) (15, 15') ou la(les) vis de réglage respective(s) interagissent par l'intermédiaire d'une partie de forme sphérique (24, 24').

9. Unité laser selon l'une des revendications 7 ou 8, **caractérisée par le fait que** la(les) vis de réglage (12) est(sont) reçue(s) apte(s) à tourner dans une plaque de support (19) fixée sur l'élément de montage (3) et, de préférence, un dissipateur thermique (9) est fixé sur la plaque de support (19), lequel présente des cavités pour la(les) vis de réglage (12).

10. Unité laser selon l'une des revendications 7 à 9, **caractérisée par le fait que** la (les) vis de réglage (12) est (sont) apte (s) à être fixées de façon à ne pas tourner.

11. Unité laser selon l'une des revendications 7 à 10, **caractérisée par le fait que** la (les) vis de réglage (12, 12') est (sont) apte(s) à être fixée(s) de façon à ne pas tourner respectivement au moyen d'un contre-écrou pour une fixation permanente d'une position ajustée.

12. Unité laser selon l'une des revendications 1 à 11, **caractérisée par le fait que** l'élément de retenue (14) est fixé par une liaison adhésive pour une fixation permanente d'une position ajustée.

13. Module laser (1) comportant une pluralité d'unités laser (2) selon l'une des revendications 1 à 11.

14. Module laser (1) selon la revendication 13 comportant trois unités laser (2) selon l'une des revendications 1 à 12, les unités de montage des unités laser étant combinées en un trajet de faisceau commun, dans lequel des miroirs de déviation sont fixés.
